# EUROPÄISCHE PATENTSCHRIFT

(11) **EP 2 663 967 B1**
(45) Veröffentlichungstag und Bekanntmachung des Hinweises auf die Patenterteilung: **07.10.2015**
(21) Anmeldenummer: 11810581.6
(22) Anmeldetag: 24.12.2011
(51) Int. Cl.: B60R 25/20, G01V 3/12, E05F 15/73, G07C 9/00

(54) **SENSOREINHEIT ZUM BERÜHRUNGSLOSEN BETÄTIGEN EINER FAHRZEUGTÜR**
SENSOR UNIT FOR CONTACTLESSLY ACTUATING A VEHICLE DOOR
UNITÉ DE DÉTECTION POUR L'ACTIONNEMENT SANS CONTACT D'UNE PORTIÈRE DE VÉHICULE

(30) Priorität: 11.01.2011 DE 102011008277
(43) Veröffentlichungstag der Anmeldung: 20.11.2013
(73) Patentinhaber: Brose Fahrzeugteile GmbH & Co. KG, Hallstadt, 96103 Hallstadt (DE)
(72) Erfinder: WÜRSTLEIN, Holger, 97475 Zeil am Main (DE); GUNREBEN, Andre, 96103 Hallstadt (DE)
(74) Vertreter: FDST Patentanwälte
(86) Internationale Anmeldenummer: PCT/EP2011/006569
(87) Internationale Veröffentlichungsnummer: WO 2012/095157

(56) Entgegenhaltungen:
- EP-A1- 2 159 362
- WO-A1-2006/056425
- DE-A1- 10 206 968
- DE-A1- 19 620 059
- DE-A1-102004 046 903

## Beschreibung

Die Erfindung betrifft eine Sensoreinheit zum berührungslosen Betätigen, das heißt zum Öffnen oder Schließen einer Fahrzeugtür, insbesondere einer Heckklappe.

Für einen Benutzer eines Fahrzeugs ist es unter Umständen wünschenswert, eine Fahrzeugtür, insbesondere die Heckklappe eines Kofferraums, berührungslos zu öffnen oder zu schließen. Ein solches Bedürfnis besteht unter anderem dann in besonderem Maße, wenn das Fahrzeug be- oder entladen wird und der Benutzer beide Hände zum Tragen eines Gegenstandes wie etwa eines Getränkekastens einsetzt.

In jüngerer Zeit sind Vorrichtungen zum berührungslosen Betätigen einer Heckklappe bekannt geworden, die mittels kapazitiver Messtechnik eine bestimmte Beinbewegung eines Fahrzeugnutzers, zum Beispiel eine Fußbewegung in Richtung oder unter den hinteren Stoßfänger des Fahrzeugs, als Türöffnungswunsch erkennen, und daraufhin eine automatische Öffnung der Heckklappe veranlassen.

Eine solche Vorrichtung ist insbesondere aus der DE 10 2008 063 366 A1 bekannt. Diese Vorrichtung umfasst zwei voneinander beabstandete kapazitive Näherungssensoren sowie eine Steuereinheit zur Auswertung der kapazitiven Messsignale. Die zwei Näherungssensoren erfassen zwei getrennte Detektionsbereiche, wobei die Heckklappe nur dann betätigt wird, wenn in beiden Detektionsbereichen die Annäherung eines Körperteils detektiert wird.

Zur Messung von Kapazitäten und deren Änderungen wird bei kapazitiven Näherungssensoren typischerweise das sogenannte "Ladungstransfer-Verfahren" eingesetzt. Hierzu wird eine Sensorelektrode elektrisch aufgeladen und mit einer Referenzkapazität parallel geschaltet. Zur Auswertung wird die an der Referenzkapazität anliegende Spannung herangezogen. Das "Ladungstransfer-Verfahren" zeichnet sich durch eine hohe Genauigkeit aus, ist aber vergleichsweise zeit- und energieintensiv.

Die üblicherweise eingesetzten kapazitiven Näherungssensoren messen meist die zwischen einer Sensorelektrode einerseits und Masse andererseits gebildete Kapazität. Für den Anwendungsbereich der berührungslosen Fahrzeugtürbetätigung ist die Kapazitätsmessung gegen Masse allerdings nachteilig. Durch die zu der Sensoreinheit unmittelbar benachbarten, geerdeten Karosserieteile wird nämlich eine vergleichsweise große Grundkapazität gebildet, durch die die Messung einer sehr kleinen Kapazitätsänderung - wie sie durch die Anwesenheit eines Körperteils im Erfassungsbereich der Sensoreinheit typischerweise hervorgerufen wirderschwert wird. Die Grundkapazität wird üblicherweise durch den Einbau eines "Driven Shields", das die Fahrzeugmasse gegen die Sensorelektrode abschirmt, verringert. Ein "Driven Shield" setzt allerdings die Detektionsreichweite des kapazitiven Näherungssensors herab, was für die sichere Erkennung eines durch eine Beinbewegung angezeigten Türöffnungswunsches wiederum nachteilig ist.

Aus der DE 10 2009 025 212 A1 ist eine weitere Vorrichtung zum berührungslosen Betätigen einer Heckklappe bekannt. Diese Einrichtung umfasst einen kapazitiven Näherungssensor mit zwei Elektroden, zwischen denen eine dritte, elektrisch mit der Masse des Fahrzeugs verbundene Elektrode angeordnet ist. Diese Elektrodenanordnung erlaubt, die Kapazität der beiden äußeren Elektroden gegeneinander zu messen, ohne dass dazu eine zusätzliche Referenzkapazität benötigt wird. Bei dieser Vorrichtung werden die beiden Elektroden des kapazitiven Sensors periodisch elektrisch aufgeladen und entladen. Mittels einer Steuereinheit wird dabei der Verlauf der zwischen den Elektroden bestehenden, elektrischen Spannung ausgewertet. Erreicht diese Spannung einen vorgegebenen Schwellwert, wird von der Steuereinheit ein die Fahrzeugtür betätigendes Signal ausgegeben.

Aus der WO 2006/ 056425 A1 ist schließlich ein kapazitiver Sensor mit einer Elektrodenanordnung bekannt, die drei sandwichartig übereinander angeordnete Elektroden aufweist, nämlich eine äußere Sensorelektrode ("Außen"), eine innere Sensorlektrode ("Innen") und eine zwischen diesen Sensorelektroden angeordnete Abschirmelektrode ("Shield"). Die beiden Sensorelektroden alternativ zueinander betrieben, wobei die jeweils nicht betriebene Sensorelektrode mit Masse kurzgeschlossen ist. Die jeweils betriebene Sensorelektrode wird mit einem Wechselstromsignal beaufschlagt. Die Abschirmungselektrode wird als sogenanntes "Driven Shield" gleichphasig angesteuert.

Der Erfindung liegt die Aufgabe zugrunde, eine effiziente und fehlerunanfällige Sensoreinheit zum berührungslosen Betätigen einer Fahrzeugtür sowie ein Fahrzeug mit dieser Sensoreinheit anzugeben. Der Erfindung liegt ferner die Aufgabe zugrunde, ein verbessertes Verfahren zur berührungslosen Betätigung einer Fahrzeugtür mittels einer solchen Sensoreinheit anzugeben.

Bezüglich einer kapazitiven Sensoreinheit wird diese Aufgabe erfindungsgemäß gelöst durch die Merkmale des Anspruchs 1. Bezüglich eines diese Sensoreinheit enthaltenden Fahrzeugs wird die Aufgabe erfindungsgemäß gelöst durch die Merkmale des Anspruchs 8. Bezüglich eines Verfahrens zur berührungslosen Betätigung einer Fahrzeugtür wird die Aufgabe ferner erfindungsgemäß gelöst durch die Merkmale des Anspruchs 11. Vorteilhafte Ausgestaltungen und Weiterbildungen sind Gegenstand der Unteransprüche.

Die erfindungsgemäße kapazitive Sensoreinheit umfasst eine dreiteilige Elektrodenanordnung mit zwei Sendeelektroden und einer dazwischen beabstandet angeordneten Empfangselektrode.

Bei der Sensoreinheit werden qualitative Kapazitätswerte zwischen den Sendeelektroden und der Empfangselektrode erfasst, wodurch eine Referenzkapazität, wie sie beim Ladungstransfer-Verfahren verwendet wird, nicht mehr benötigt wird. Der Betrieb der Sensoreinheit ist somit zeit- und energiesparend. Auch eine Kopplung der Sensoreinheit mit einem "Driven Shield" oder dergleichen zur Abschirmung gegen die Fahrzeugmasse ist dadurch nicht nötig.

Während des Betriebs der Sensoreinheit wird von den Sendeelektroden - in der für kapazitive Sensoren typischen Weise - ein elektrisches Streufeld, beziehungsweise Detektionsfeld, in den umgebenden Raum abgestrahlt. Das Detektionsfeld definiert einen Erfassungs- oder Detektionsbereich um die Sensoreinheit herum. Der Begriff "Erfassungsbereich" oder "Detektionsbereich" bezeichnet allgemein den messempfindlichen Bereich der Sensoreinheit, also denjenigen Bereich, innerhalb dessen die Sensoreinheit die Annäherung eines Fahrzeugnutzers detektieren kann. Das elektrische Streufeld wird bei einer Annäherung des Fahrzeugnutzers durch dessen Körpergewebe messbar beeinflusst.

Durch die Kombination zweier Sendeelektroden mit einer gemeinsamen Empfangselektrode werden dabei ressourcensparend zwei Teil-Detektionsbereiche gebildet, die eine doppelte Näherungsmessung ermöglichen. Durch die Redundanz der Detektionsbereiche kann die den Türöffnungswunsch anzeigende Fußbewegung von anderen Näherungssignalen, z.B. dem von einer an dem Stoßfänger entlangstreichenden Katze hervorgerufenen Signal, unterschieden werden. Neben dem reinen Redundanzeffekt ergeben sich dabei auch durch die Anordnung der zwei örtlich versetzten Detektionsfelder zusätzliche Informationen, durch die das Risiko einer Fehlauslösung deutlich reduziert ist. Insbesondere kann durch die Reihenfolge und Signalstärke, in der eine Annäherung in jedem der beiden Detektionsfelder detektiert wird, auf die Art des detektierten Gegenstandes geschlossen werden. So spricht z.B. auf eine unter dem Kraftfahrzeug laufende Katze hauptsächlich der untere Detektionsbereich an, während der obere Detektionsbereich nicht oder nur schwach beeinflusst wird. Bei Annäherung eines menschlichen Beins (Türöffnungswunsch) werden dagegen beide Detektionsfelder beeinflusst. Im oberen Detektionsbereich wird die Annäherung des Beins aber früher detektiert als im unteren Detektionsbereich.

Grundsätzlich kann anstelle der Kombination zweier Sendeelektroden mit einer gemeinsamen Empfangselektrode äquivalentermaßen auch eine Kombination zweier Empfangselektroden mit einer gemeinsamen Sendeelektrode eingesetzt werden.

In der bevorzugten Anwendung handelt es sich bei der Fahrzeugtür um eine Heckklappe. In einer geeigneten Einbausituation lässt sich die Sensoreinheit in diesem Fall zweckmäßigerweise an oder - aus optischen Gründen bevorzugt - innerhalb eines Kraftfahrzeug-Stoßfängers anordnen. Die letztgenannte Variante hat den zusätzlichen Vorteil, dass die Sensoreinheit vor äußeren Einflüssen, insbesondere vor Witterungseinwirkungen, geschützt ist. Grundsätzlich kann die erfindungsgemäße Sensoreinheit aber auch zum berührungslosen Betätigen anderer Fahrzeugtüren eingesetzt werden. In jedem Fall ist die Sensoreinheit aber bevorzugt in einem Bereich nahe der zu betätigenden Fahrzeugtür, an oder innerhalb des Fahrzeugs, angeordnet.

In einer vorteilhaften Ausführungsform erstrecken sich die Elektrodenelemente bei Einbau in den Stoßfänger im Wesentlichen über dessen gesamte Breite. Sende- und Empfangselektroden sind dabei geeigneterweise parallel entlang der Stoßfängerlängsrichtung angeordnet. Dadurch deckt die Sensoreinheit einen großen detektierbaren Bereich ab.

In einer bevorzugten Einbauform sind eine erste Sendeelektrode und die Empfangselektrode als Flachleiter, und die zweite Sendeelektrode als Rundleiter ausgeführt, wobei die erste Sendeelektrode insbesondere über der zweiten Sendeelektrode angeordnet ist. Diese Ausbildung der Sendeelektroden bewirkt in dem der ersten Sendeelektrode zugeordneten Erfassungsbereich eine vergleichsweise gerichtete, schmale Ausbildung des zugehörigen Detektionsfeldes, während das der zweiten Sendeelektrode zugehörige Detektionsfeld breiter, d.h. stärker aufgefächert ist. Diese Kombination verschiedener Detektionsfeldgeometrien ist insbesondere für die Anordnung der Elektroden in dem Fahrzeugstoßfänger vorteilhaft.

In einer weiteren vorteilhaften Ausbildungsform sind die erste Sendeelektrode und die Empfangselektrode in einer gemeinsamen, vorzugsweise extrudierten, kombinierten Flachleiterelektrode integriert.

In einer zweckmäßigen Variante der Erfindung bestehen die Elektroden aus schlaufenförmig angeordneten Einzelleitungen. Durch eine gegensinnige Orientierung der Wicklung der Sendeelektroden einerseits und der Empfangselektrode andererseits ergibt sich eine annähernd gleiche Kapazitätsverteilung entlang der von den Elektroden überspannten Fläche.

In vorteilhafter Ausführung umfasst die Sensoreinheit eine Steuereinheit zur Erzeugung eines elektrischen Sendesignals, das den Sendeelektroden zugeführt wird, sowie zur Auswertung eines - von der Empfangselektrode empfangenen - elektrischen Empfangssignals. Die von der Steuereinheit versendeten und empfangenen Signale sind zweckmäßigerweise Wechselspannungen. Die Steuereinheit ist insbesondere durch einen Mikrocontroller mit einer darin implementierten Steuersoftware gebildet, oder umfasst zumindest - neben anderen analogen oder digitalen Schaltungselementen - einen solchen.

Bei der vorstehend beschriebenen Elektrodenanordnung, bei der die Sendeelektroden einerseits und die Empfangselektrode andererseits durch gegensinnig gewundene Leiterschlaufen gebildet sind, ist die Steuereinheit vorzugsweise zwischen den beiden Sendeelektroden angeordnet. Wenn die Elektroden an oder in dem Fahrzeug-Stoßfänger angebracht oder integriert sind, ist dabei zweckmäßigerweise auch die Steuereinheit an oder in dem Stoßfänger integriert. Bei dieser, näherungsweise symmetrischen und elektrodennahen Anordnung der Steuereinheit sind die Elektroden zweckmäßigerweise direkt an die Steuereinheit angeschlossen. Elektrische Zuleitungen zwischen den Elektroden und der Steuereinheit, die aufwändig geschirmt werden müssten oder andernfalls das Messergebnis verfälschen könnten, werden auf diese Weise überflüssig und sind entsprechend bevorzugt auch nicht vorgesehen.

In einer vorteilhaften Ausführung der Erfindung ist die Steuereinheit schaltungs- und/oder programmtechnisch dazu ausgebildet, das Sendesignal aus zwei zueinander - insbesondere um einen Phasenwinkel von 90° - phasenverschobenen Teilsignalen zu erzeugen, dieses kombinierte Sendesignal an die Sendelektroden zu versenden, und aus den entsprechenden Teilsignalen eines von der Empfangselektrode empfangenen Empfangssignals ein Differenzsignal zu bilden. Die Steuereinheit gibt dabei ein Auslösesignal dann aus, wenn das Differenzsignal ein vorgegebenes (Auslöse-)Kriterium erfüllt. Als Auslösekriterium ist hierbei insbesondere ein Schwellwertvergleich vorgesehen, im Zuge dessen die Steuereinheit das Differenzsignal mit einem hinterlegten Schwellwert vergleicht und bei Überschreitung des Schwellwerts das Auslösesignal erzeugt.

Das vorstehend beschriebene Verfahren knüpft an die an sich aus der Datenübertragung als "IQ-Modulation" bekannte Technik an. Bei der herkömmlichen "IQ-Modulation" wird in einer Sendestation jedem der beiden Teil(träger)signale ein Datenstrom aufmoduliert. Die beiden - in der Regel verschiedenen - Datenströme werden dann nach Trennung der beiden Teilsignale in einer Empfangsstation von dem jeweiligen Teil(träger)signal demoduliert. Durch die IQ-Modulation wird somit eine zweikanalige Informationsübertragung über ein gemeinsames Signal ermöglicht. Im Gegensatz zu dieser bekannten Technik wird bei dem erfindungsgemäß bevorzugten Verfahren den Teilsignalen durch die Steuereinheit jedoch keine Information aufmoduliert. Die beiden Teilsignale werden lediglich im Feldraum, das heißt zwischen der Aussendung über die Sendeelektrode und dem Empfang durch die Empfangselektrode durch die gegebenenfalls anwesende Körpermaterie eines Fahrzeugnutzers modifiziert, wobei hier beide Teilsignale eine gleiche Phasenänderung erfahren. Das Verfahren nutzt hierbei den Umstand, dass infolge des Phasenunterschieds der beiden Teilsignale sich die im Feldraum verursachte Phasenänderung im jeweiligen Realteil der beiden Teilsignale mit unterschiedlichem Vorzeichen äußert. Im Differenzsignal wird die Phasenänderung daher verstärkt abgebildet, während rauschbedingte Fluktuationen der Teilsignale im Differenzsignal statistisch reduziert werden. Durch die Verwendung der beiden Teilsignale wird somit mit einfachen Mitteln ein verbessertes Signal-Rausch-Verhältnis erzielt.

Um das Empfangssignal der beiden Sendeelektroden einfach trennen zu können, ist in vorteilhafter Weiterbildung vorgesehen, dass die Steuereinheit bei der Übermittlung des Sendesignals zeitlich alternierend zwischen den Sendeelektroden wechselt. Die Steuereinheit beaufschlagt also zu jedem Zeitpunkt stets nur eine der beiden Sendeelektroden, so dass auch das Empfangssignal zu jedem Zeitpunkt stets nur von einer der beiden Sendeelektroden stammt.

Um das Restrisiko einer Fehlauslösung der Sensoreinheit durch unberechtigte Personen oder zum Beispiel Tiere auszuschließen, ist die Sensoreinheit vorzugsweise mit einem vollautomatisch öffnenden Türschließsystem ("Keyless Go") gekoppelt, das eine Betätigung der Fahrzeugtür nur dann freigibt, wenn das Türschließsystem - zum Beispiel durch einen Funksender im Schlüssel des Fahrzeugnutzers - entriegelt ist.

Nachfolgend ist ein Ausführungsbeispiel der Erfindung anhand einer Zeichnung näher erläutert. Darin zeigen:
- Fig. 1: in Frontansicht einen Stoßfänger eines Kraftfahrzeugs mit einer kapazitiven Sensoreinheit zum berührungslosen Betätigen einer Kraftfahrzeug-Heckklappe, wobei die Sensoreinheit zwei Sendeelektroden, eine gemeinsame Empfangselektrode sowie eine Steuereinheit umfasst,
- Fig. 2: in Darstellung gemäß Fig. 1 eine Ausführungsform der Sensoreinheit, bei der die Empfangselektrode mit einer der Sendeelektroden in einem gemeinsamen Flachleiter integriert ist,
- Fig. 3: in Darstellung gemäß Fig. 1 eine Ausführungsform der Sensoreinheit, bei der die Sendeelektroden und die Empfangselektrode als schlaufenförmige Einzelleiter ausgebildet sind, wobei die Schlaufen der Sendeelektroden einerseits und der Empfangselektrode andererseits einen entgegengesetzte Wicklungssinn aufweisen,
- Fig. 4: in Seitenansicht den Stoßfänger mit der daran angeordneten Sensoreinheit, zusammen mit einem sich zwischen den Sendeelektroden und der Empfangselektrode ausbildenden elektrischen Streufeld,
- Fig. 5: in einem komplexen (d.h. die komplexe Zahlenebene abbildenden) Zeigerdiagramm zwei zueinander um 90° phasenversetzte Teilsignale eines von der Steuereinheit an die Sendeelektroden emittierten Sendesignals,
- Fig. 6: in Darstellung gemäß Fig. 5 zwei entsprechende Teilsignale eines von der Empfangselektrode empfangenen Empfangssignals,
- Fig. 7: in einem zeitlichen Diagramm den Verlauf eines ersten Teilsignals (I-Kanal, hier invertiert dargestellt) und eines zweiten Teilsignals (Q-Kanal) des Empfangssignals und eines daraus gebildeten Differenzsignals, und
- Fig. 8: in einer grob schematischen Seitenansicht ein Heckteil eines Kraftfahrzeugs, welches mit einer Sensoreinheit zum berührungslosen Betätigen der Heckklappe versehen ist, sowie ein Bein eines sich annähernden Fahrzeugnutzers.

Einander entsprechende Teile und Größen sind in allen Figuren stets mit den gleichen Bezugszeichen versehen.

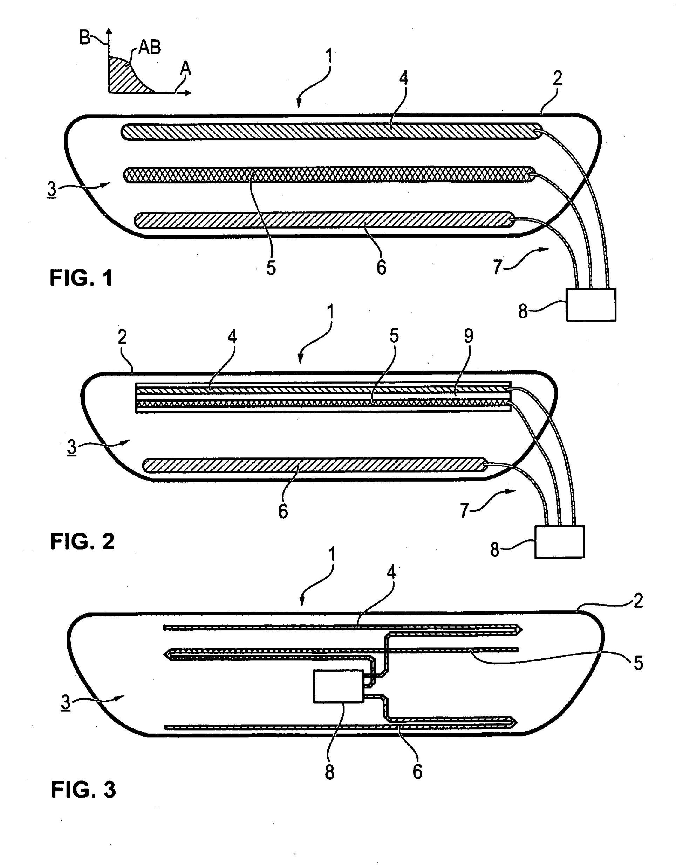

Die Fig. 1 bis 3 zeigen verschiedene Ausführungsformen einer kapazitiven Sensoreinheit 1, die innerhalb eines (Kraftfahrzeug-)Stoßfängers 2 angeordnet ist. Eine Elektrodenanordnung 3 der Sensoreinheit 1 umfasst eine erste Sendeelektrode 4, eine Empfangselektrode 5 und eine zweite Sendeelektrode 6. Die Elektrodenanordnung 3 ist (bei den Fig. 1 und 2) über elektrische Zuleitungen 7 mit einer Steuereinheit 8 verbunden. In den Ausführungsbeispielen gemäß Fig. 1 und 2 sind die Zuleitungen 7 mit einer Schirmung gegen elektromagnetische Störfelder ausgestattet, wodurch eine Verlagerung der Steuereinheit 8 aus dem Witterungseinflüssen ausgesetzten Bereich des Stoßfängers 2 in den Trockenraum des zugehörigen Kraftfahrzeugs möglich ist.

Die Elektroden 4, 5 und 6 der Sensoreinheit 1 erstrecken sich parallel zu einer Stoßfängerlängsrichtung A im Wesentlichen über die gesamte Breite des Stoßfängers 2. Die Elektroden 4, 5 und 6 befinden sich zueinander beabstandet in einer Elektrodenebene AB, die von der Stoßfängerlängsrichtung A und einer Stoßfängerquerrichtung B aufgespannt wird. Die Empfangselektrode 5 ist hierbei zwischen den Sendeelektroden 4 und 6, jeweils mit Abstand zu den letzteren, angeordnet.,

Im Ausführungsbeispiel gemäß Fig. 1 sind die erste Sendeelektrode 4 und die Empfangselektrode 5 als jeweils separate Flachleiter ausgeführt. Die zweite Sendeelektrode 6 kann ebenfalls durch einen Flachleiter gebildet sein. Bevorzugt diese zweite Sendeelektrode 6 aber, zur Erzielung einer breiteren Auffächerung des zugehörigen Detektionsfeldes, als Rundleiter ausgeführt.

Das Ausführungsbeispiel gemäß Fig. 2 unterscheidet sich von dem vorstehend beschriebenen Ausführungsbeispiel dadurch, dass dort die Sendeelektrode 4 und die Empfangselektrode 5 zusammen in einem extrudierten Flachleiterstreifen 9 integriert sind. Die zweite Sendeelektrode 6 ist dagegen bevorzugt - wie in der Ausführungsform gemäß Fig. 1 - als Rundleiter ausgebildet.

Bei der in Fig. 3 gezeigten Ausführungsform sind die Elektroden 4, 5 und 6 jeweils durch eine Einzelleitung - insbesondere mit rundem Querschnitt - gebildet, wobei diese Einzelleitungen jeweils in Form einer offenen Schlaufe in der Elektrodenebene AB verlegt sind. Die Wicklungsrichtung der die Empfangselektrode 5 bildenden Leiterschlaufe ist dabei gegensinnig zu der Wicklungsrichtung der die Sendeelektroden 4 und 6 bildenden Leiterschlaufen orientiert.

Bei der Elektrodenanordnung gemäß Fig. 3 sind die Elektroden 4, 5 und 6 direkt - insbesondere ohne zwischengeschaltete, ggf. geschirmte Zuleitungen 7 - mit der Steuereinheit 8 verbunden, die hier zwischen den Sendeelektroden 4 und 6 inmitten der von diesen aufgespannten Fläche an oder in dem Stoßfänger 2 angeordnet ist.

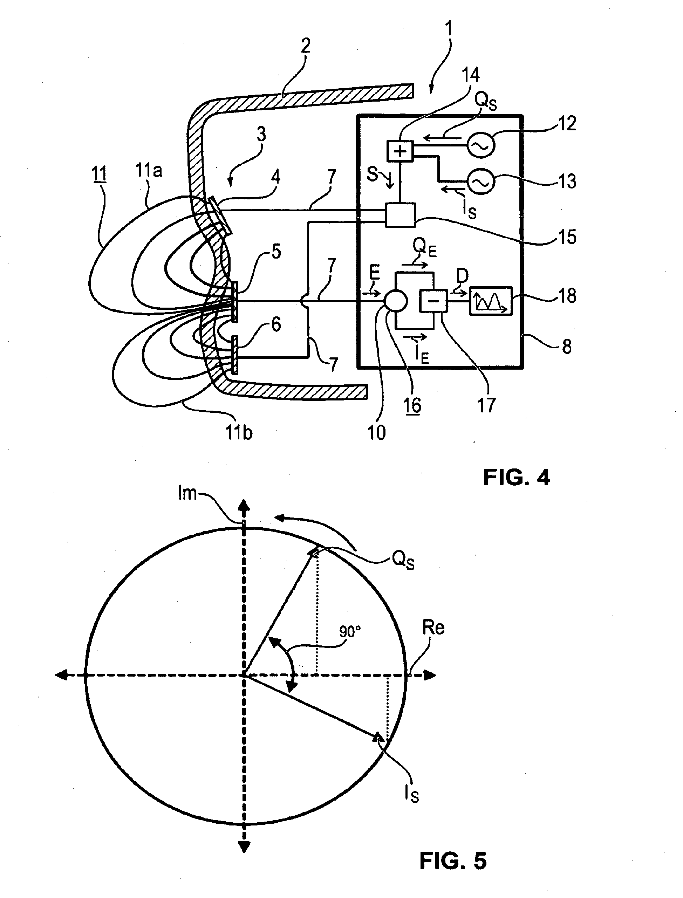

Wie schematisch in Fig. 4 dargestellt ist, sind die Elektroden 4, 5 und 6 zum Schutz vor äußeren Einflüssen insbesondere innerhalb des Stoßfängers 2 angeordnet.

Im Betrieb der Sensoreinheit 1 wird von der Steuereinheit 8 eine elektrische Wechselspannung an die Sendeelektroden 4 und 6 angelegt, die im Folgenden als Sendesignal S bezeichnet ist. Unter Wirkung dieses Sendesignals S bildet sich, ausgehend von den Sendeelektroden 4 und 6, ein elektrisches Streufeld 11 in einem dem Stoßfänger 2 vorgelagerten Raumvolumen aus, das nachfolgend als Detektions- oder Erfassungsraum bezeichnet ist. Im Einzelnen erstreckt sich ein Teilfeld 11 a des Streufeldes 11 zwischen der Sendeelektrode 4 und der Empfangselektrode 5, während sich ein weiteres Teilfeld 11 b des Streufeldes 11 zwischen der Sendeelektrode 6 und der Empfangselektrode 5 erstreckt.

Durch eine nicht gezeigte Schirmung wird optional sichergestellt, dass das Streufeld 11 der Elektrodenanordnung 3 nur in den Halbraum außerhalb des Stoßfängers 2 abstrahlt. Dadurch wird der Erfassungs- oder Detektionsraum der Sensoreinheit 1 im Wesentlichen auf den Halbraum außerhalb des Fahrzeugstoßfängers 2 beschränkt, wodurch insbesondere ausgeschlossen wird, dass die Sensoreinheit 1 nicht durch Störfelder aus dem Fahrzeuginneren beeinflusst wird.

Die Elektrodenanordnung 3 wird in einem Zeitmultiplexbetrieb betrieben, indem durch eine Schalteinheit 15 der Steuereinheit 8 alternierend im Wechsel stets nur eine der Sendeelektroden 4 oder 6 mit dem Sendesignal S versorgt wird. Hierdurch können die beiden Teilfelder 11 a und 11 b über die gemeinsame Empfangselektrode 5 getrennt voneinander überwacht werden.

In der in Fig. 4 gezeigten Ausführung umfasst die Steuereinheit 8 zwei Wechselspannungsquellen 12 und 13, die zwei zueinander um 90° phasenverschobene, insbesondere zeitlich sinus- bzw. cosinusförmig wechselnde elektrische Teilsignale I_{S} ("I-Kanal") und Q_{S} (Q-Kanal) erzeugen. Fig. 5 zeigt beispielhaft die zwei erzeugten Teilsignale I_{S} und Q_{S} in einer Zeigerdarstellung in der komplexen ZahlenEbene, die durch eine reelle Achse Re und eine imaginäre Achse Im aufgespannt wird. Die Projektionen der Zeigerspitzen auf die reelle Achse Re entsprechen hierbei den (messbaren) reellen Werten der Teilsignale I_{S} und Q_{S}. Diese Teilsignale I_{S} und Q_{S} werden von einem Addierer 14 zu dem Sendesignal S kombiniert und über die Schalteinheit 15 abwechselnd an die Sendeelektroden 4 und 6 der Elektrodenanordnung 3 gesendet.

Die Empfangselektrode 5 ist mit einem Shuntwiderstand 10 oder einer anderen Stromwandlerschaltung der Steuereinheit 8 verbunden, die den während des Betriebs der Elektrodenanordnung 3 auftretenden Verschiebestrom in eine elektrische Spannung konvertiert, die nachfolgend als Empfangssignal E bezeichnet ist. Das Empfangssignal E wird bevorzugt durch eine (nicht explizit gezeigte) Verstärkerschaltung verstärkt, bevor es von der Steuereinheit 8 ausgewertet wird.

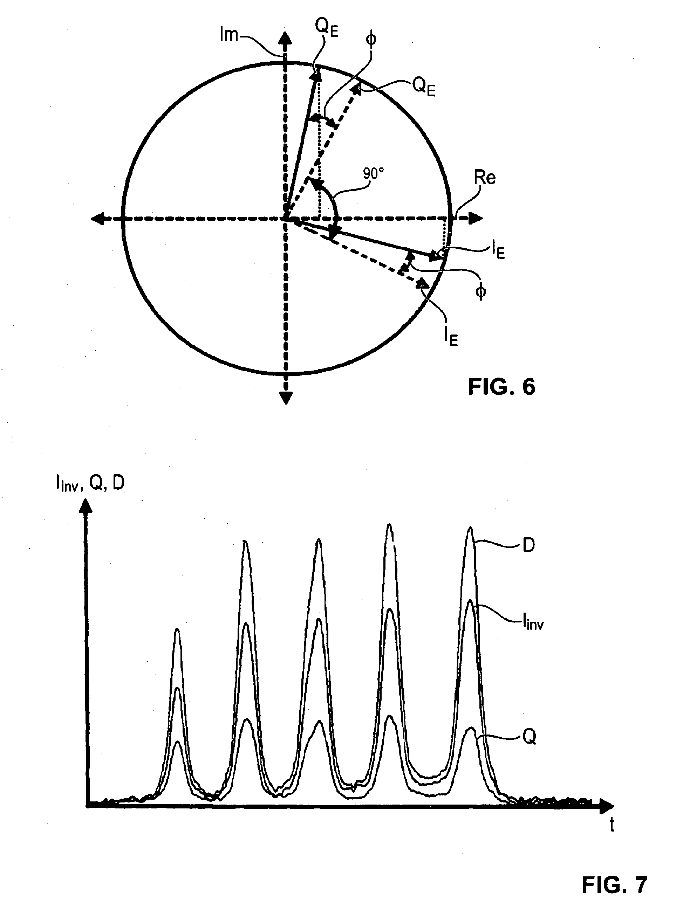

Das Empfangssignal E enthält ebenfalls die Informationen aus den gesendeten Teil-Signalen I_{S} und Q_{S}. Insbesondere setzt sich das Empfangssignal E mathematisch ebenfalls aus einer Addition zweier sinus- bzw. cosinusförmiger Teilsignale I_{E} und Q_{E}, die dem I-Kanal bzw. O-Kanal des Sendesignals S entsprechen und ebenfalls zueinander einen Phasenversatz von 90° haben. Die Teilsignale I_{E} und Q_{E} sind in Fig. 6 in einer Fig. 5 entsprechenden Zeigerdarstellung in der komplexen Zahlenebene dargestellt. Mittels eines Kanalteilers 16 der Steuereinheit 8 werden diese Teilsignale I_{E} und Q_{E} - analog zu der bei der IQ-Modulation gebräuchlichen Technik - aus dem Empfangssignal E extrahiert.

Der Phasenversatz zwischen dem Sendesignal S und dem (zum Verschiebestromfluss proportionalen) Empfangssignal E bestimmt sich aus dem Verhältnis des - konstanten - ohmschen Widerstand und des kapazitiven Blindwiderstands der Sensoreinheit 1. Im stationären (ungestörten) Zustand, d.h. in Abwesenheit eines Körperteils im Erfassungsraum der Sensoreinheit 1, ist dieses Verhältnis konstant, so dass auch der Phasenversatz zwischen dem Sendesignal S und dem Empfangssignal E zeitlich unverändert ist. Insbesondere kann somit der stationäre Blindwiderstand durch die Steuereinheit 8 kompensiert werden, so dass das Sendesignal S und das (kompensierte) Empfangssignal E im stationären Zustand zumindest näherungsweise in Phase stehen. Für den stationären Zustand sind die Teilsignale I_{E} und Q_{E} in Fig. 6 beispielhaft gestrichelt dargestellt.

Durch die Einbringung des Körperteils, beispielsweise eines Beines eines Fahrzeugnutzers, in das Streufeld 11 wird die Kapazität der Elektrodenanordnung 3 beeinflusst. Hierdurch ändert sich der kapazitive Blindwiderstand der Sensoreinheit 1, während der ohmsche Widerstand konstant bleibt, wodurch sich die Phasenlage des Empfangssignals E im Vergleich zu dem Sendesignal S um einen Phasenwinkel φ ändert. Hiermit ändert sich -wie in Fig. 6 mit durchgezogenen Linien dargestellt - auch die Phasenlage beider Teilsignale I_{E} und Q_{E} um den Phasenwinkel φ. Aufgrund des 90°-Phasenversatzes zwischen den Teilsignalen I_{E} und Q_{E} äußert sich die Phasenänderung in den reellen Werten der Teilsignale I_{E} und Q_{E} - wie aus Fig. 6 erkennbar ist - allerdings gegensätzlich. Im dargestellten Beispiel nimmt der reelle Wert des Teilsignals I_{E} aufgrund der Phasenänderung zu, während der reelle Wert des Teilsignals Q_{E} abnimmt.

Diesen Effekt nutzt die Steuereinheit 8 aus, indem sie die reellen Werte der Teilsignale I_{E} und Q_{E} zyklisch jeweils zum Nulldurchgang der Anregungsspannung S abtastet und hieraus mittels eines Differenzierers 17 ein Differenzsignal D bildet. Das Differenzsignal D wird weitergeleitet auf einen Vergleicher 18, der das Differenzsignal D mit einem hinterlegten Schwellwert vergleicht und Auslösesignale Sₐₘ sowie Sₐₛ erzeugt, wenn das Differenzsignal D den Schwellwert überschreitet. Der Vorteil der Differenzbildung liegt dabei insbesondere darin, dass infolge der gegensätzlichen Auswirkung der Phasenänderung auf die reellen Werte der beiden Teilsignale I_{E} und Q_{E} die Phasenänderung im Differenzsignal verstärkt wird, wie aus Fig. 7 erkennbar ist. Durch die Differenzbildung des I- und Q-Kanals wird also mit anderen Worten eine stärkere Pegeländerung erzielt, als wenn nur ein Kanal ausgewertet würde. Rauschanteile der Teilsignale I_{E} und Q_{E} werden dagegen durch die Differenzbildung statistisch ausgemittelt.

Die Steuereinheit 8 umfasst in bevorzugter Ausbildung einen Mikrocontroller, in dem ein das vorstehend beschriebene Verfahren automatisch ausführendes Steuerprogramm implementiert ist. Insbesondere sind der Differenzierer 17 und der Vergleicher 18 bevorzugt softwaretechnisch als Teile des Steuerprogramms implementiert. Die übrigen genannten Bestandteile der Steuereinheit 8 sind vorzugsweise schaltungstechnisch realisiert.

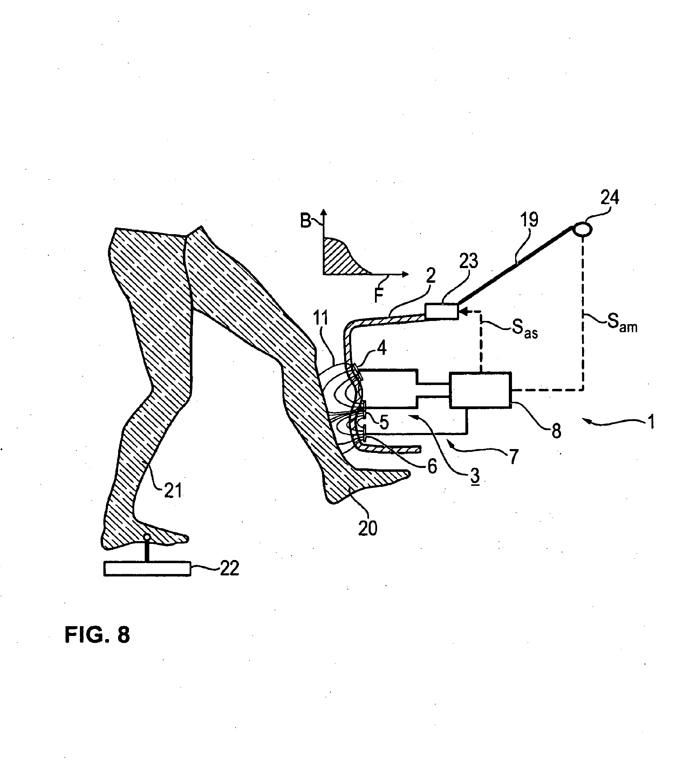

Fig. 8 zeigt einen schematischen Ausschnitt eines Heckbereichs eines Fahrzeugs während des berührungslosen Betätigens einer Heckklappe 19 durch ein Bein 20 eines Fahrzeugnutzers. Der Fahrzeugnutzer ist durch sein anderes Bein (Standbein 21) mit dem Boden 22 geerdet. Die Heckklappe 19 ist mit einem Türschloss 23 und einer Motoreinheit 24 zum automatischen Öffnen und Schließen ausgestattet.

Nähert der Fahrzeugnutzer sein Bein 20 in einer Richtung F an den Stoßfänger 2 an, so dringt das Bein 20 in den vom Streufeld 11 ausgefüllten Erfassungsraum der Sensoreinheit 1 ein. Das geerdete Bein 21 wirkt als zusätzliche Elektrode, durch die die Kapazität der Elektrodenanordnung 3 verringert wird, so dass das - wie vorstehend beschrieben - in der Steuereinheit 8 ermittelte Differenzsignal D den Schwellwert überschreitet.

Die Steuereinheit 8 sendet das daraufhin erzeugte Auslösesignal Sₐₛ an das Türschloss 23, und das Auslösesignal Sₐₘ an den Heckklappenmotor 24. Durch die Auslösesignale Sₐₛ bzw. Sₐₘ werden das Türschloss 23 entriegelt und der Heckklappenmotor 24 aktiviert, wodurch die Heckklappe 19 automatisch geöffnet wird.

### Bezugszeichenliste

- 1: Sensoreinheit
- 2: Stoßfänger
- 3: Elektrodenanordnung
- 4: Sendeelektrode
- 5: Empfangselektrode
- 6: Sendeelektrode
- 7: Zuleitung
- 8: Steuereinheit
- 9: Flachleiterstreifen
- 10: Shuntwiderstand
- 11: Streufeld
- 11a: Teilfeld
- 11b: Teilfeld
- 12: Phasenverschobene Spannungsquelle
- 13: Spannungsquelle
- 14: Addierer
- 15: Schalteinheit
- 16: Kanalteiler
- 17: Differenzierer
- 18: Vergleicher
- 19: Heckklappe
- 20: Bein
- 21: Standbein
- 22: Boden
- 23: Türschloss
- 24: Motoreinheit

- A: Stoßfängerlängsrichtung
- AB: Elektrodenebene
- B: Stoßfängerquerrichtung
- D: Differenzsignal
- E: Empfangssignal
- I_{S}: Teilsignal (I-Kanal)
- I_{E}: Empfangenes Teilsignal (I-Kanal)
- Im: Imaginäre Achse
- Q_{E}: Empfangenes Teilsignal (Q-Kanal)
- Q_{S}: Teilsignal (Q-Kanal)
- Re: Reelle Achse
- S: Sendesignal
- Sₐₛ: Schlossauslösesignal
- Sₐₘ: Motorauslösesignal
- S: Sendesignal
- φ: Phasenwinkel

## Patentansprüche

1. Kapazitive Sensoreinheit (1) zum berührungslosen Betätigen einer Fahrzeugtür (19) eines Fahrzeugs, umfassend eine Elektrodenanordnung (3) mit mindestens drei voneinander beabstandeten Elektroden (4, 5, 6),
**dadurch gekennzeichnet,**
**dass** die Elektrodenanordnung (3) eine erste Sendeelektrode (4), eine zweite Sendeelektrode (6) und eine dazwischen angeordnete Empfangselektrode (5) umfasst.

2. Sensoreinheit (1) nach Anspruch 1,
**dadurch gekennzeichnet,**
**dass** die erste Sendeelektrode (4) und die Empfangselektrode (5) als Flachleiter, und die zweite Sendeelektrode (6) als Rundleiter ausgeführt sind.

3. Sensoreinheit (1) nach Anspruch 1 oder 2,
**dadurch gekennzeichnet,**
**dass** die erste Sendeelektrode (4) und die Empfangselektrode (5) in einem gemeinsamen Flachleiterstreifen (9) integriert sind.

4. Sensoreinheit (1) nach einem der Ansprüche 1 bis 3,
**dadurch gekennzeichnet,**
**dass** die Elektroden (4, 5, 6) aus schlaufenförmigen Einzelleitungen gebildet sind, wobei die Schlaufenwicklung der Sendeelektroden (4, 6) gegensinnig zu der Schlaufenwicklung der Empfangselektrode (5) orientiert ist.

5. Sensoreinheit (1) nach Anspruch 4,
**gekennzeichnet durch**
eine Steuereinheit (8) zur Erzeugung eines Sendesignals (S) für die Sendeelektroden (4, 6) sowie zur Auswertung eines von der Empfangselektrode (5) empfangenen Empfangssignals (E), wobei die Steuereinheit (8) zwischen den beiden Sendeelektroden (4,6) angeordnet ist.

6. Sensoreinheit (1) nach einem der Ansprüche 1 bis 5,
**gekennzeichnet durch**
eine Steuereinheit (8) zur Erzeugung eines Sendesignals (S) für die Sendeelektroden (4, 6) sowie zur Auswertung eines von der Empfangselektrode (5) empfangenen Empfangssignals (E), wobei die Steuereinheit (8) dazu eingerichtet ist,
- das Sendesignal (S) aus zwei zueinander phasenverschobenen Teilsignalen (I_{S}, Q_{S}) zu erzeugen,
- das Empfangssignal (E) in zwei entsprechende Teilsignale (I_{E}, Q_{E}) zu zerlegen,
- aus den Teilsignalen (I_{E},Q_{E}) des Empfangssignals (E) ein Differenzsignal (D) zu bilden, und
- ein die Betätigung der Fahrzeugtür (19) veranlassendes Auslösesignal (Sₐₘ, Sₐₛ) dann auszugeben, wenn das Differenzsignal (D) ein vorgegebenes Auslösekriterium erfüllt.

7. Sensoreinheit (1) nach einem der Ansprüche 5 und 6,
**dadurch gekennzeichnet,**
**dass** die Steuereinheit (8) dazu eingerichtet ist, das Sendesignal (S) zeitlich alternierend an die erste Sendeelektrode (4) und die zweite Sendeelektrode (6) zu senden.

8. Fahrzeug, insbesondere Kraftfahrzeug, mit einer Fahrzeugtür, insbesondere einer Heckklappe (19), und mit einer Sensoreinheit (1) nach einem der Ansprüche 1 bis 7 zum berührungslosen Betätigen der Fahrzeugtür.

9. Fahrzeug nach Anspruch 8,
**dadurch gekennzeichnet,**
**dass** die Sensoreinheit (1) an oder innerhalb eines Fahrzeugstoßfängers (2) angeordnet ist.

10. Fahrzeug nach Anspruch 8 oder 9,
**dadurch gekennzeichnet,**
**dass** sich die Elektroden (4, 5, 6) im Wesentlichen über die gesamte Breite des Stoßfängers (2) parallel zu einer Stoßfängerlängsrichtung (A) erstrecken.

11. Verfahren zum berührungslosen Betätigen einer Fahrzeugtür (19) mittels einer Sensoreinheit (1) nach einem der Ansprüche 1 bis 7,
**dadurch gekennzeichnet,**
- **dass** ein Sendesignal (S) aus zwei zueinander phasenverschobenen Teilsignalen (I_{S}, Q_{S}) erzeugt und an die Sendeelektroden (4, 6) gesendet wird,
- **dass** ein von der Empfangselektrode (5) empfangenes Empfangssignal (E) in zwei entsprechende Teilsignale (I_{E}, Q_{E}) zerlegt wird,
- **dass** aus den Teilsignalen (I_{E}, Q_{E}) des Empfangssignals (E) ein Differenzsignal (D) gebildet wird, und
- **dass** ein die Betätigung der Fahrzeugtür (19) veranlassendes Auslösesignal (Sₐₘ, Sₐₛ) ausgegeben wird, wenn das Differenzsignal (D) ein vorgegebenes Auslösekriterium erfüllt.

## Claims

1. Capacitive sensor unit (1) for the contactless actuation of a vehicle door (19) of a vehicle, comprising an electrode arrangement (3) having at least three electrodes (4, 5, 6) which are at a distance from one another,
**characterised in that**,
the electrode arrangement (3) comprises a first transmitting electrode (4), a second transmitting electrode (6) and a receiving electrode (5) arranged therebetween.

2. Sensor unit (1) according to claim 1,
**characterised in that**,
the first transmitting electrode (4) and the receiving electrode (5) are designed as flat conductors, and the second transmitting electrode (6) is designed as a round conductor.

3. Sensor unit (1) according to claim 1 or 2,
**characterised in that**,
the first transmitting electrode (4) and the receiving electrode (5) are integrated in a mutual flat conductor strip (9).

4. Sensor unit (1) according to one of claims 1 to 3,
**characterised in that**,
the electrodes (4, 5, 6) are formed from loop-shaped individual wires, wherein the loop winding of the transmitting electrodes (4, 6) is orientated contrary to the loop winding of the receiving electrode (5).

5. Sensor unit (1) according to claim 4,
**characterised by**
a control unit (8) for the generation of a transmitting signal (S) for the transmitting electrodes (4, 6) as well as for the evaluation of a receiving signal (E) received by the receiving electrode (5), wherein the control unit (8) is arranged between the two transmitting electrodes (4, 6) .

6. Sensor unit (1) according to one of claims 1 to 5,
**characterised by**
a control unit (8) for the generation of a transmitting signal (S) for the transmitting electrodes (4, 6) as well as for the evaluation of a receiving signal (E) received by the receiving electrode (5), wherein the control unit (8) is equipped to
- generate the transmitting signal (S) from two partial signals (Iₛ, Qₛ) which are phase-shifted with respect to each other,
- strip the receiving signal (E) into two corresponding partial signals (I_{E}, Q_{E}),
- form a differential signal (D) from the partial signals (I_{E}, Q_{E}) of the receiving signal (E), and
- then emit a trigger signal (Sₐₘ, Sₐₛ) causing the actuation of the vehicle door (19) if the differential signal (D) fulfils a predetermined trigger criterion.

7. Sensor unit (1) according to one of claims 5 and 6,
**characterised in that**,
the control unit (8) is equipped to transmit the transmitting signal (S) with temporal alternation to the first transmitting electrode (4) and the second transmitting electrode (6).

8. Vehicle, in particular motor vehicle, having a vehicle door, in particular a tailgate (19), and having a sensor unit (1) according to one of claims 1 to 7 for the contactless actuation of the vehicle door.

9. Vehicle according to claim 8,
**characterised in that**,
the sensor unit (1) is arranged on or within a vehicle bumper (2).

10. Vehicle according to claim 8 or 9,
**characterised in that**,
the electrodes (4, 5, 6) extend substantially over the entire width of the bumper (2) in parallel to a bumper longitudinal direction (A).

11. Method for the contactless actuation of a vehicle door (19) by means of a sensor unit (1) according to one of claims 1 to 7,
**characterised in that**,
- a transmitting signal (S) is generated from two partial signals (Iₛ, Qₛ) which are phase-shifted with respect to each other and is transmitted to the transmitting electrodes (4, 6),
- a receiving signal (E) received by the receiving electrode (5) is stripped into two corresponding partial signals (I_{E}, Q_{E}),
- a differential signal (D) is formed from the partial signals (I_{E}, Q_{E}) of the receiving signal (E), and
- a trigger signal (Sₐₘ, Sₐₛ) causing the actuation of the vehicle door (19) is emitted if the differential signal (D) fulfils a predetermined trigger criterion.

## Revendications

1. Unité de détection capacitive (1) pour l'actionnement sans contact d'une portière de véhicule (19) d'un véhicule, comprenant un agencement d'électrodes (3) comprenant au moins trois électrodes (4, 5, 6) espacées les unes des autres,
**caractérisée**
**en ce que** l'agencement d'électrodes (3) comprend une première électrode démission (4), une deuxième électrode d'émission (6) et, agencée entre celles-ci, une électrode de réception (5).

2. Unité de détection (1) selon la revendication 1,
**caractérisée**
**en ce que** la première électrode d'émission (4) et l'électrode de réception (5) sont réalisées sous forme de conducteur plat, et la deuxième électrode d'émission (6) sous forme de conducteur rond.

3. Unité de détection (1) selon la revendication 1 ou la revendication 2,
**caractérisée**
**en ce que** la première électrode d'émission (4) et l'électrode de réception (5) sont intégrées dans une bande commune de conducteur plat (9).

4. Unité de détection (1) selon l'une des revendications 1 à 3,
**caractérisée**
**en ce que** les électrodes (4, 5, 6) sont formées par des conducteurs individuels en forme de boucle, l'enroulement de boucle des électrodes d'émission (4, 6) étant orienté selon un sens inverse à l'enroulement de boucle de l'électrode de réception (5).

5. Unité de détection (1) selon la revendication 4,
**caractérisée**
**par** une unité de commande (8) pour produire un signal d'émission (S) destiné aux électrodes d'émission (4, 6), ainsi que pour traiter un signal de réception (E) reçu par l'électrode de réception (5), l'unité de commande (8) étant agencée entre les deux électrodes d'émission (4, 6).

6. Unité de détection (1) selon l'une des revendications 1 à 5,
**caractérisée**
**par** une unité de commande (8) pour produire un signal d'émission (S) destiné aux électrodes d'émission (4, 6), ainsi que pour traiter un signal de réception (E) reçu par l'électrode de réception (5), l'unité de commande (8) étant configurée pour
- produire le signal d'émission (S) en deux signaux partiels (Iₛ, Qₛ) mutuellement déphasés,
- décomposer le signal de réception (E) en deux signaux partiels (I_{E}, Q_{E}) correspondants,
- former un signal de différence (D) à partir des signaux partiels (I_{E}, Q_{E}) du signal de réception (E), et
- délivrer un signal de déclenchement (Sₐₘ, Sₐₛ) entraînant l'actionnement de la portière de véhicule (19), lorsque le signal de différence (D) remplit un critère de déclenchement prédéterminé.

7. Unité de détection (1) selon l'une des revendications 5 et 6,
**caractérisée**
**en ce que** l'unité de commande (8) est configurée pour émettre le signal d'émission (S) de manière alternée dans le temps vers la première électrode d'émission (4) et la deuxième électrode d'émission (6).

8. Véhicule, notamment véhicule automobile, comprenant une portière de véhicule, notamment un hayon arrière (19), et comprenant une unité de détection (1) selon l'une des revendications 1 à 7 pour l'actionnement sans contact de la portière de véhicule.

9. Véhicule selon la revendication 8,
**caractérisé**
**en ce que** l'unité de détection (1) est agencée sur ou à l'intérieur d'un parechocs (2) du véhicule.

10. Véhicule selon la revendication 8 ou la revendication 9,
**caractérisé**
**en ce que** les électrodes (4, 5, 6) s'étendent sensiblement sur la totalité de la largeur du parechocs (2), parallèlement à une direction longitudinale (A) du parechocs.

11. Procédé pour l'actionnement sans contact d'une portière de véhicule (19) au moyen d'une unité de détection (1) selon l'une des revendications 1 à 7,
**caractérisé**
- **en ce que** l'on produit un signal d'émission (S) en deux signaux partiels (Iₛ, Qₛ) mutuellement déphasés, qui sont envoyés aux électrodes d'émission (4, 6),
- **en ce que** l'on décompose un signal de réception (E) reçu par l'électrode de réception (5), en deux signaux partiels (I_{E}, Q_{E}) correspondants,
- **en ce que** l'on forme, à partir des signaux partiels (I_{E}, Q_{E}) du signal de réception (E), un signal de différence (D), et
- **en ce que** l'on émet un signal de déclenchement (Sₐₘ, Sₐₛ) entraînant l'actionnement de la portière de véhicule (19), lorsque le signal de différence (D) remplit un critère de déclenchement prédéterminé.
